# FASCICULE DE BREVET EUROPEEN

(11) **EP 0 635 786 B1**
(45) Date de publication et mention de la délivrance du brevet: **13.11.1996**
(21) Numéro de dépôt: 94401403.4
(22) Date de dépôt: 22.06.1994
(51) Int. Cl.: G06F 11/00, G06F 12/02

(54) **Dispositif de stockage de données**
Einrichtung zur Speicherung von Daten
Device for storing data

(30) Priorité: 19.07.1993 FR 9308832
(43) Date de publication de la demande: 25.01.1995
(73) Titulaire: SGS-THOMSON MICROELECTRONICS S.A., F-94250 Gentilly (FR)
(72) Inventeur: Carre, Laurent, F-75116 Paris (FR); Correard, Patrick, F-75116 Paris (FR)
(74) Mandataire: Schmit, Christian Norbert Marie

(56) Documents cités:
- EP-A- 0 068 099
- US-A- 5 214 611

## Description

La présente invention a pour objet un dispositif de stockage de données, notamment de stockage de données de type dit AUDIO, dont la nature est telle qu'elles peuvent supporter, de temps en temps, des défauts de mémorisation sans que les conséquences en soient trop perceptibles à l'utilisation, notamment l'audition. Il peut en être de même des données d'images, notamment lorsqu'elles sont compressées. On utilise donc ici le terme AUDIO pour désigner de telles données. Dans le but de réduire le coût de stockage de ces informations AUDIO on souhaite utiliser des mémoires électroniques statiques ou dynamiques de type AUDIO: c'est-à-dire des mémoires comportant des points mémoires défectueux.

Pour qu'une telle réalisation soit possible, il faut que le taux d'erreurs ne dépasse pas une certaine valeur et que par ailleurs la présentation de ces erreurs soit uniformément répartie durant la réutilisation, la retransmission du signal AUDIO. D'une manière connue, pour limiter les conséquences possibles de ces défauts, on ajoutera à l'information numérique représentative du signal AUDIO un code de détection et de correction d'erreurs. Ces codes de protection sont assez efficaces sur les défauts isolés. Ils sont de type connu. Ils nécessitent la mise en oeuvre d'algorithmes de correction d'erreurs.

En résumé, pour pouvoir utiliser des mémoires de type AUDIO, on est confronté à deux contraintes. La première contrainte consiste à ne pas dépasser dans la mémoire un taux d'erreurs donné: TMAX. Deuxièmement, les défauts doivent être uniformément répartis dans le plan de mémoire de la mémoire. Or les mémoires à accès aléatoire, dites RAM, de type AUDIO comportent deux types de défauts. D'une part, elles comportent des points mémoires défectueux isolés. Et d'autre part, des points mémoires défectueux groupés. Ce dernier type de défauts est notamment présent lorsqu'il y a des rangées ou des colonnes mémoires défectueuses. On constate que ce dernier type de défauts n'est pas compatible avec la deuxième contrainte évoquée précédemment. Le choix de mémoires AUDIO devrait être alors limité à celles dont le taux de points de mémoires défectueux isolés est inférieur à TMAX et dont le taux de points mémoires défectueux groupés est nul. L'inconvénient de cette situation est qu'il faut trier les mémoires audio utilisables pour connaître celles qui sont susceptibles de bien fonctionner. En outre certaines mémoires sont rejetées à l'issue du tri.

Pour résoudre ce type de problème il est déjà connu, à la mise sous tension, avant l'écriture de données, de faire une vérification de l'état de la mémoire et des cellules à adresser. Lorsqu'un défaut est constaté on constitue une table des défauts, on la sauvegarde, et on effectue un déroutage des adresses à destination des cellules mémoires défectueuses vers des cellules mémoires de redondance. Ces opérations ont l'inconvénient d'une part d'être complexes et d'autre part de provoquer une perte de temps à l'utilisation. Le résultat d'une telle utilisation est aussi que le taux d'utilisation de la mémoire n'est plus de 100%, et que le débit moyen de la mémoire est plus lent. L'inconvénient des techniques anciennes est que le développement d'une application avec de telles mémoires est dépendant de la qualité dite "zéro défaut" des mémoires utilisées.

Le but premier de l'invention tel que revendiquée dans la revendication 1 est de s'affranchir de toutes ces contraintes et de créer des circuits de stockage de données dans des mémoires de type AUDIO, de mauvaise qualité, sans avoir à se préoccuper de la qualité exacte de ces mémoires. Dans l'invention il suffit de se satisfaire de la connaissance du taux d'erreurs T donné par le fabricant de la mémoire AUDIO et de vérifier qu'il est inférieur à TMAX. En pratique ces mémoires AUDIO sont des mémoires dynamiques mais elles pourraient être des mémoires statiques ou même des mémoires non volatiles du moment qu'elles sont à accès aléatoire.

Le document EP-A-0 068 099 comporte un circuit d'adressage aléatoire d'une mémoire de visualisation prévu pour répartir des données successives en différents endroits de la mémoire. Le document n'enseigne cependant pas comment résister aux groupement de défauts.

Dans l'invention telle que revendiquée dans la revendication indépendante, pour résoudre le problème ainsi présenté, on tire partie du fait que les données AUDIO qui sont éditées (qui sont diffusées dans des haut-parleurs) sont cohérentes successivement les unes avec les autres. Lors de l'écriture, des données successives, correspondant ainsi à des sons successifs, sont réparties, aléatoirement, ou plutôt pseudo-aléatoirement, en différents endroits de la mémoire. A la lecture, on relit selon une même séquence pseudo-aléatoire la succession des données AUDIO stockées. Compte tenu du caractère aléatoire du stockage on s'affranchit alors sans difficulté des défauts groupés.

A la lecture, à l'audition, les défauts même groupés sont vus comme uniformément répartis dans le plan mémoire. On peut alors utiliser des mémoires ayant un taux de défaut, inférieur aux taux maximum supporté, sans contrainte sur le type de ce défaut.

En outre les données sont écrites et lues séquentiellement à partir d'une adresse de début, les adresses étant dans l'ensemble fournies par un générateur de codes pseudo-aléatoires. Après initialisation du générateur d'adresses pseudo-aléatoires à la valeur de départ, le système produit automatiquement les adresses suivantes. L'écriture et la lecture sont donc préférentiellement séquentielles. Pour éviter le caractère séquentiel quelquefois gênant de l'accès aux données, il est prévu dans l'invention que le générateur de codes pseudo-aléatoires possède par ailleurs des entrées de forçage pour pouvoir être forcé à n'importe quelle valeur et ainsi provoquer un démarrage d'une séquence ou au moins une lecture ou écriture à n'importe quel endroit prévu.

Pour faciliter la gestion de l'information dans les plans mémoires des mémoires électroniques, qu'il s'agisse de mémoires AUDIO ou autres, ces plans mémoires sont généralement divisés en secteurs. La mise en oeuvre la plus immédiate de la sectorisation d'un plan mémoire dans le cadre de l'invention conduit, si on explore tous les mots mémoires d'un secteur avant de passer à un secteur suivant, à retenir pour chaque secteur un taux d'erreurs nécessaire égal au taux d'erreurs global de la mémoire divisé par le nombre de secteurs. Ce taux risquerait alors d'être trop faible, et la mémoire ne pourrait être utilisée.

Dans l'invention telle que revendiquée dans la revendication 1, pour résoudre ce problème supplémentaire, on a eu l'idée, à chaque adresse pseudo-aléatoire nouvelle créée par le générateur, de changer de secteur. Dans une variante préférée ce changement de secteur n'est lui-même pas aléatoire ni pseudo-aléatoire mais est progressif, modulo le nombre de secteurs. Dans ces conditions, d'une part le taux d'erreurs peut rester celui donné par le constructeur. D'autre part l'adressage reste simple. Dans ce cas, une adresse est alors constituée de deux parties : une première partie correspondant au numéro de secteur et une autre partie complètement pseudo-aléatoire.

Par ailleurs, un autre problème subsiste qui est lié à la taille des mots mémoires à stocker. En effet, on constate que dans certains cas relatifs à des problèmes de fabrication, un ensemble de cellules contiguës sur le plan mémoire sont défectueuses. Dans ces conditions, si on écrit un mot entier dans un groupe de cellules contiguës à chaque accès, le dispositif d'adressage pseudo-aléatoire devient inefficace. On risque de créer des paquets de par exemple, quatre bits mauvais dans le cas où on a affaire à des mots de quatre bits. Par ailleurs, si on utilise des cycles de lecture/modification/écriture pour n'écrire qu'un seul bit à la fois, on perd le gain en temps d'accès à l'information.

Pour résoudre cet autre problème, dans une variante de l'invention, telle que revendiquée dans la revendication dépendante 2, on part de l'hypothèse qu'il n'y a pas de corrélation entre les défauts de plusieurs boîtiers mémoires différents. On constitue alors physiquement un plan mémoire composite à bus de données de plusieurs bits, par exemple quatre bits, par mise en parallèle de plusieurs circuits-boîtiers mémoires de un bit, quatre circuits par exemple. On accède alors en parallèle mêmes simultanément à des cellules mémoires uniques situées à des mêmes adresses pseudo-aléatoires dans chacun de ces circuits-boîtiers mémoires. Chaque circuit-boîtier mémoire délivre alors sur un fil une information d'un bit. Ce fil forme alors un fil d'un bus de données de quatre fils de l'ensemble des circuits-boîtiers mémoires.

L'invention a donc pour objet un dispositif de stockage de données cohérentes successives les unes avec les autres dans des mots mémoires d'une mémoire à accès aléatoire tel que revendiqué dans la revendication 1.

D'autres objects sont résolus de façon avantageuse grâce aux caractéristiques des revendications dépendantes 2 à 9.

L'invention sera mieux comprise à la lecture de la description qui suit et des figures qui l'accompagnent. Celles-ci ne sont données qu'à titre indicatif et nullement limitatif de l'invention. Les figures montrent :
- Figure 1 : une mémoire selon l'invention;
- Figures 2a et 2b : un exemple de réalisation d'un générateur pseudo-aléatoire selon l'invention ;
- Figure 3 : un organigramme d'utilisation du générateur pseudo-aléatoire en mode inverse ;
- Figure 4 : une particularité de réalisation du circuit de l'invention pour des circuits intégrés mémoires de type dynamique.

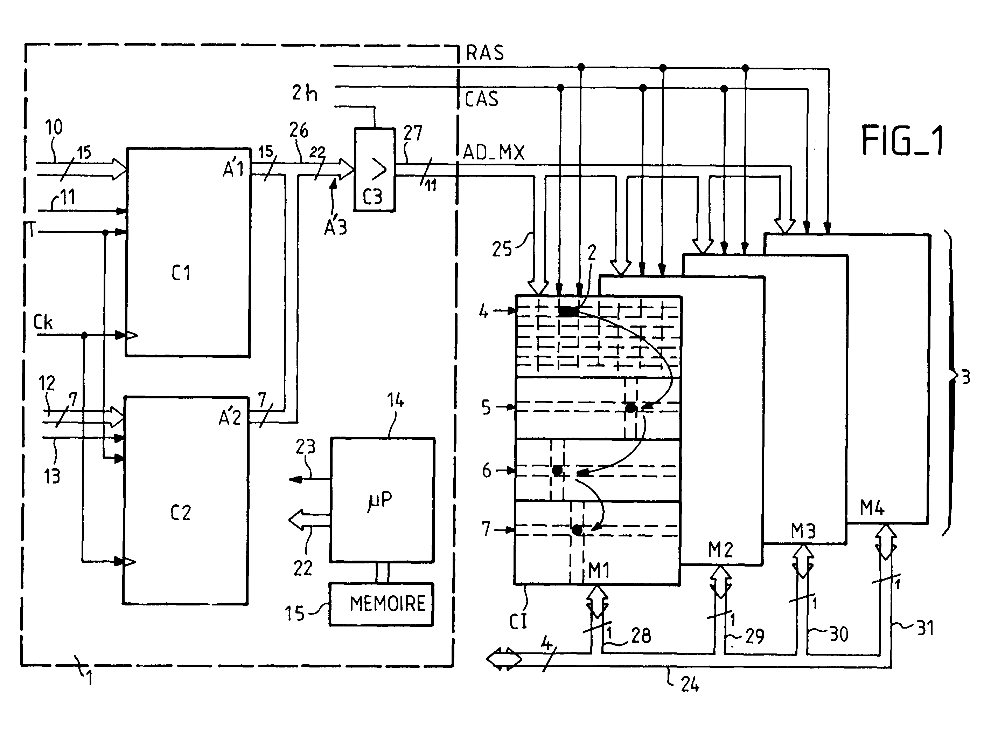

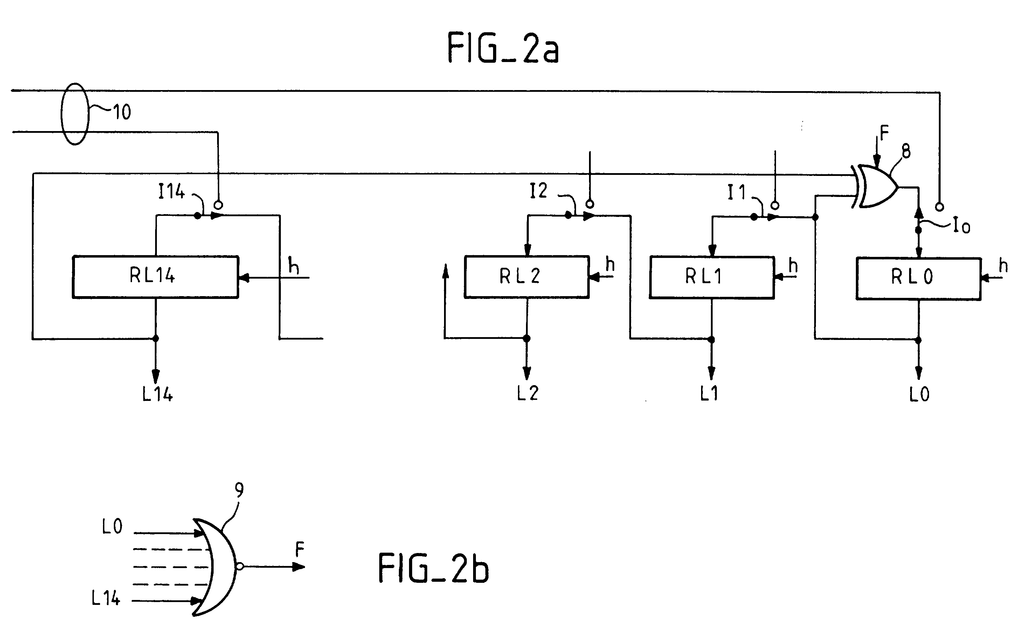

La figure 1 montre un dispositif 1 de stockage de données successives dans des mots mémoires 2 d'une mémoire à accès aléatoire 3. Selon l'invention, le dispositif de stockage comporte un générateur d'adresses pseudo-aléatoires C1, C2, C3 pour répartir les données successives à des adresses pseudo-aléatoires 4, 5, 6, 7, etc... successives. La figure 2 montre un exemple de réalisation d'un tel générateur pseudo-aléatoire. Celui-ci peut néanmoins être quelconque et être en particulier du type décrit dans le livre "Digital Systems Testing and Testable Design", édité par Computer Science Press en 1990, dû à Miron ABRAMOVICI, Melvin A. BREUER, et Arthur D. FRIEDMAN, pages 432 à 441.

Selon une variante préférée de l'invention, le générateur d'adresses pseudo-aléatoires comporte un premier circuit C1 pour délivrer successivement les mots binaires pseudo-aléatoires de P bits représentant des premières parties d'un signal d'adresse. Dans un exemple P vaut 15. Le générateur comporte également un deuxième circuit C2 pour délivrer en synchronisation des mots binaires contigus de Q bits. Dans un exemple Q vaut 7. Ces mots binaires sont respectivement disponibles aux sorties A'1 et A'2 des circuits C1 et C2 sur des bus de P et Q bits réunis ensemble pour former un bus A'3 de (Q + P) bits.

Le fonctionnement du circuit C1-C2 est le suivant. A partir d'un état initial, un même signal d'incrémentation T est appliqué aux circuits C1 et C2. La transmission de ce signal est synchronisée par un déclenchement des circuits C1 et C2 au moyen d'un signal d'horloge CK agissant comme validation. Le signal T est tout simplement un signal impulsionnel. Le circuit C1 est un circuit délivrant un signal pseudo-aléatoire avec une période de 2^{P} états binaires différents. A chaque cycle, le circuit C1 reproduit les mêmes étapes pseudo-aléatoires.

La figure 2a montre un exemple de constitution du circuit C1. Celui-ci est formé par un jeu de quinze registres RL0 à RL14 montés ensemble en registre à décalage. Ainsi, la sortie du registre RL0 est connectée à l'entrée du registre RL1. Celle du registre RL1 est connectée à l'entrée du registre RL2 et ainsi de suite. La sortie du registre RL14 ainsi que la sortie du registre RL0 sont appliquées aux deux entrées d'une porte OU-EXCLUSIF, XOR, 8 dont la sortie est appliquée en entrée du registre RL0. Les sorties des registres RL0 à RL14 débitent des signaux d'adresse L0 à L14. Tous ces registres sont déclenchés par un signal h résultant de la validation du signal T par le signal d'horloge CK.

Normalement, un tel générateur d'états pseudo-aléatoires, possédant P sorties, n'est susceptible de produire que 2^{P}-1 états différents. En effet, l'état 000...000, ou dans certains cas l'état 111... 111, n'est pas susceptible de déclencher l'évolution du générateur. Ces états binaires sont appelés puits parce qu'ils bloquent l'évolution du générateur. Ils sont détectés et décodés dans l'invention. Le résultat de ce décodage est utilisé pour forcer le circuit C1 dans un état. Dans un exemple, le circuit de décodage comporte tout simplement une porte NOR 9 qui reçoit les signaux L0 à L14. Lorsque tous ces signaux sont nuls, la porte NOR 9 produit un signal F de forçage à l'état 1. Ce signal F est appliqué sur la porte XOR 8 et force la sortie de cette porte 8 à l'état 1. En conséquence, à l'impulsion h suivante le signal L0, qui était à zéro comme tous les signaux L0 à L14, est porté à 1. Dans ces conditions, la génération des codes pseudo-aléatoires peut recommencer. A l'issue de 2^{P}-1 pas, le microprocesseur doit recharger C1 avec "tout à zéro".

Le circuit C2 est de préférence constitué par un compteur, ici un compteur par 128 possédant sept sorties et qui évolue progressivement d'un cran à chaque pas. L'évolution des sorties des circuits C2 sont facilement prévisibles.

On a représenté pour le circuit C1, figure 2a, une batterie de commutateurs I0 à I14 interposés entre les sorties des registres à décalage et les entrées des registres à décalage suivants. Ces commutateurs I0 à I14 permettent de mettre en relation les entrées des registres RL0 à RL14 avec les quinze fils d'un bus 10 d'entrée. Le signal de commande des commutateurs I0 à I14 est appliqué sur une entrée 11 du circuit C1. Il en va de même des sorties du compteur du circuit C2 qui peuvent être reliées aux sept fils d'un bus 12 au moment de l'application d'une commande sur un fil de commande 13 du compteur C2 lorsque cette commande est appliquée à un état binaire disponible sur les bus 10 et 12 et est appliquée en entrée des registres RL0 et RL14 et à des entrées de forçage du compteur C2. Une fois que ces chargements sont effectués, à l'impulsion h suivante ces états de forçage sont disponibles sur le bus 26 en sortie des circuits C1 et C2.

Il arrive quelquefois pour l'enregistrement de signaux AUDIO qu'on soit confronté à l'enregistrement de silences. Plutôt que d'occuper alors une place importante en mémoire pour stocker de tels silences, on préfère en mesurer la durée et, selon un protocole adapté, enregistrer un mot codé correspondant à la durée de ce silence. Un problème à résoudre est alors de détecter, à un instant t qu'on a eu affaire à un silence de durée n, qui a commencé au temps t-n, et qu'on voudrait enregistrer à partir de l'adresse correspondant au temps t-n+1. On veut enregistrer un mot codé (de préférence avec un code d'erreurs adapté) à partir de l'adresse correspondant à temps t-n+1.

Le problème est alors de revenir à l'adresse pseudo-aléatoire, parfaitement déterministe, correspondant au temps t-n+1. Ce qui est connu à l'instant t est, d'une part, le nombre n de pas effectués et d'autre part l'état des sorties des circuits C1 et C2 à cet instant t. On veut le connaître à l'instant t-n+1.

Pour connaître alors l'état des sorties du circuit C2 à l'instant t-n+1, il est simple de faire une soustraction, modulo 128, de cet état à la date t moins la valeur n elle-même. Par contre, pour le circuit C1 il faudrait le faire tourner à l'envers ce qui est impossible. Dans l'invention, on résout ce problème en utilisant un microprocesseur 14 susceptible de mettre alors en oeuvre un programme contenu dans une mémoire 15 et dont le but va être de forcer les sorties du circuit C1 dans un état à déterminer. Le programme contenu dans la mémoire 15 permet d'une part de déterminer cet état, et, à l'issue, de l'appliquer en sortie du circuit C1 selon le mode décrit ci-dessus avec les bus 10 et 12 et la commande 11.

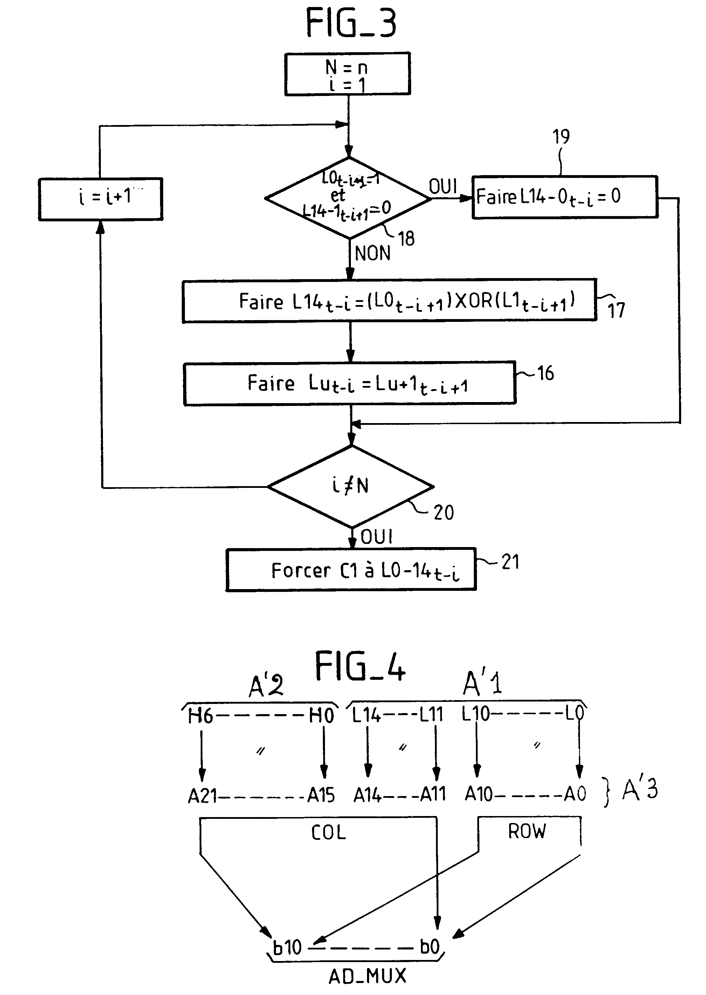

La figure 3 montre l'organigramme des actions à faire entreprendre dans ce but par le microprocesseur 14. A chaque pas de comptage arrière, compte tenu de ce qu'on a affaire à un registre à décalage, il faut en une instruction 16 calculer la sortie théorique d'un registre RL à l'instant t - i en la rendant égale à la sortie d'un registre RL u + 1 à l'instant t - i + 1. Ceci est valable pour tous les registres sauf le dernier. En effet le registre RL14 ne possède pas de suivant. Compte tenu de la fonction XOR effectuée par la porte 8, en une instruction 17 on calcule alors la sortie théorique du registre RL14, à l'instant t - i, comme étant égale au résultat d'une fonction OU-EXCLUSIF appliquée sur les signaux binaires des sorties des registres RL0 et RL1 à l'instant t - i + 1. Pour des raisons de cohérence néanmoins l'instruction 17 est effectuée avant l'instruction 16.

Il reste à régler maintenant le problème qui survient lorsque la sortie du registre RL0 est à l'état 1 et lorsque les sorties des autres registres sont à l'état 0. En effet, l'état précédent cet état est l'état puits dont on ne peut normalement pas sortir, et dans lequel par conséquent on ne peut pas entrer logiquement en marche arrière. Dans ce but, au cours d'un test 18 effectué à chaque pas on cherche à détecter une telle situation. Quand elle se produit on force en une instruction 19 la valeur de toutes les sorties précédentes des registres RL14 à RL0 à zéro. Le test 18 est bien entendu entrepris avant l'instruction 17. L'ensemble des instructions et tests 16 à 19 est entrepris n fois. Dans ce but, on utilise un incrément i dont la valeur de départ vaut 1 et on cesse la mise en oeuvre de ce calcul lorsque i a atteint la valeur prévue.

A l'issue d'un test 20 qui rend compte de cet aboutissement, en une instruction 21, on force alors électriquement les sorties du circuit C1 aux valeurs L0 à L14 dernièrement calculées. En pratique, le microprocesseur 14 charge alors par son bus de données 22 le bus 10 du circuit C1 et commande par une sortie de commande 23 la commande 11. Il en est de même pour le circuit C2 sauf que le programme de calcul des valeurs à imposer sur le bus 12 est beaucoup plus facile. Ce calcul consiste en une simple soustraction.

La mémoire 3 est en relation avec le monde extérieur par un bus de données 24. Dans un exemple le bus 24 est un bus de 4 bits. Elle reçoit par ailleurs les adresses de lecture/écriture ou modification par un bus d'adresses 25 relié au bus 26 à (P + Q) fils produits par les circuits C1 et C2. En pratique, pour des raisons de normalisation, lorsque la mémoire 3 est du type dynamique, les bus d'adresses sont limités à 11 fils. Dans ce cas, un circuit de multiplexage C3 permet d'alimenter, deux fois plus vite, un bus 27 de 11 fils. Dans la mémoire 3, d'une manière connue, un tel bus de 11 fils est multiplexé pour reconstituer des mots d'adresses avec le nombre de bits voulus : 22 bits. Pour des raisons pratiques, le circuit 1 est un circuit intégré monolithique et on a jugé utile de lui incorporer le multiplexeur C3. Le fonctionnement de ce multiplexeur est de type connu et ne nécessite pas d'être particulièrement décrit ici. Le multiplexeur C3 est seulement commandé par un signal 2h au double de la fréquence du signal h. En variante, le bus de données 24 de la mémoire 3 ainsi que certains fils de commande CAS et RAS peuvent transiter par le circuit intégré 1.

Dans une variante préférée, la mémoire 3 est composée par une mise en parallèle de quatre modules mémoires M1 à M4 tous identiques et possédant chacun 2^{P+Q} = quatre Mega cellules mémoires chacun. Les adresses élaborées par le circuit 1 sont simultanément appliquées sur les entrées d'adresse des décodeurs d'adresse des quatre modules M1 à M4. Chacun de ces modules est relié à un bus de données à un fil. Ces quatre bus de données 28 à 31 à un fil sont assemblés en un bus 24 à quatre fils. De ce fait, on assure qu'un mot de quatre 4 bits sera chargé pour chacun de ces quatre bits respectivement dans ces quatre modules mémoires M1 à M4. On évite ainsi de devoir charger dans un module unique un mot mémoire de quatre bits représentatif d'une même information. Ceci rendrait la restauration de cette information difficile si le mot mémoire en question était défectueux.

La figure 4 montre d'une manière pratique comment sont organisés les adressages des éléments mémoires M1 à M4. En sortie du circuit C1 on dispose de 15 signaux L0 à L14. En sortie du circuit C2 on dispose des signaux H0 à H6. Dans le bus 26 on dispose, par simple juxtaposition, des signaux d'adresses A0 à A21. Pour sortir du multiplexeur C3 on dispose successivement d'une part des signaux A0 à A10 puis, alternativement, des signaux A11 à A21. En pratique, les signaux A0 à A10 sont les signaux à appliquer aux décodeurs rangées des éléments mémoires M1 à M4, alors que les signaux A11 à A21 sont à appliquer aux décodeurs colonnes. De ce fait, la présentation des secteurs de la figure 1 ne correspond que schématiquement à la réalité.

Du fait que le nombre 2^{P} d'états du circuit C1 est plus grand que le nombre 2^{Q} d'états du circuit C2 celui-ci est amené à effectuer plusieurs explorations complètes, ou rotations, avant que le circuit C1 ne délivre un même état initial. En pratique, il effectue 2^{P-Q} rotations. Dans l'exemple cité il effectue 256 rotations. Au bout de toutes ces rotations, néanmoins, on risque de se trouver dans une situation dans laquelle le circuit C1 produit un même état binaire que précédemment alors que le circuit C2 reproduirait également un même état binaire. On risquerait dans ce cas d'être limité à accéder à seulement 2^{P} mots de mémoires dans la mémoire 3. Dans ce but, avec le microprocesseur 14 et la mémoire programme 15, on met en oeuvre un programme qui compte tout simplement le nombre de rotations du compteur C2. A l'issue de 2^{P-Q} rotations, on fait avancer le circuit C2 seul d'un cran et on charge C1 à "tout à zéro". On recommence ensuite à compter ses rotations jusqu'à obtenir 256 et ainsi de suite.

## Revendications

1. Dispositif de stockage de données cohérentes successives les unes avec les autres dans des mots mémoires d'une mémoire à accès aléatoire comportant un générateur d'adresses pseudo-aléatoires pour répartir des données successives à des adresses pseudo-aléatoires dans la mémoire, caractérisé en ce qu'il comporte, dans le générateur d'adresse pseudo-aléatoire, un premier circuit pour délivrer successivement des mots binaires pseudo-aléatoires de P bits représentant des premières parties de signaux d'adresse, et un deuxième circuit pour délivrer successivement des mots binaires contigus de Q bits représentatifs de deuxièmes parties de signaux d'adresse, un dispositif pour faire évoluer en synchronisme le premier et le deuxième circuit, et un circuit pour concaténer une première et une deuxième partie de signal d'adresse et ainsi créer une adresse aléatoire de P+Q bits, afin de répartir des données successives dans des secteurs géographiques différents de la mémoire.

2. Dispositif selon la revendication 1, caractérisé en ce qu'il comporte, dans la mémoire, un arrangement de N (N=4) circuits intégrés de mémorisation organisés chacun en 2^{M} (M=22) mots mémoires dont la longueur est de R (R=1) bits, ces N circuits intégrés étant reliés, par leur bus de données de R fils, respectivement à R fils différents d'un bus de donnée de NxR fils de la mémoire, ces N circuits intégrés de mémorisation étant reliés en parallèle sur un même bus d'adresse de M fils.

3. Dispositif selon la revendication 1, caractérisé en ce que le premier et le deuxième circuit comportent des entrées de forçage pour imposer leurs sorties dans un état donné.

4. Dispositif selon la revendication 3, caractérisé en ce que le premier et le deuxième circuit possède une période pseudo-aléatoire de 2^{P} états binaires et en ce que le deuxième circuit possède une période de 2^{Q} états binaires.

5. Dispositif selon la revendication 2, caractérisé en ce que R vaut 1.

6. Dispositif selon l'une des revendications 1 à 5, caractérisé en ce qu'il comporte un circuit de calcul d'une adresse aléatoire précédente à partir de la connaissance d'une adresses courante.

7. Dispositif selon la revendication 6, caractérisé en ce que le circuit de calcul comporte un microprocesseur et une mémoire programme, le microprocesseur étant relié à cette mémoire programme pour exécuter un microprogramme contenu dans cette mémoire programme.

8. Dispositif selon l'une des revendications 1 à 7, caractérisé en ce que le circuit de concaténation comporte un multiplexeur.

9. Dispositif selon l'une des revendications 1 à 8, caractérisé en ce que la mémoire est une mémoire dynamique.

## Patentansprüche

1. Vorrichtung zur Speicherung von kohärenten Daten, die eins nach dem anderen in Speicherworten in einem Speicher mit wahlfreiem Zugriff aufeinanderfolgen, umfassend einen Pseudozufallsadressengenerator, um die aufeinanderfolgenden Daten an die pseudozufälligen Adressen im Speicher zu verteilen,
dadurch gekennzeichnet, daß sie umfaßt
im Pseudozufallsadressengenerator einen ersten Schaltkreis, um nacheinander binäre Pseudozufallsworte mit P Bits auszugeben, die die ersten Teile von Adreßsignalen darstellen, und einen zweiten Schaltkreis, um nacheinander aneinandergrenzende binäre Worte mit Q Bits auszugeben, die die zweiten Teile von Adreßsignalen darstellen, eine Vorrichtung zur Synchronisierung des ersten und des zweiten Schaltkreises und einen Schaltkreis zum Aneinanderhängen eines ersten und eines zweiten Teils des Adreßsignals, so daß eine Zufallsadresse von P + Q Bits erzeugt wird, um aufeinanderfolgende Daten in geographisch unterschiedlichen Sektoren des Speichers zu verteilen.

2. Vorrichtung nach Anspruch 1,
dadurch gekennzeichnet, daß sie umfaßt
im Speicher eine Anordnung von N (N = 4) integrierten Schaltkreisen zur Speicherung, die jeweils in 2^{M} (M = 22) Speicherworte unterteilt sind, deren Länge R (R = 1) Bits beträgt, wobei diese N integrierten Schaltkreise über ihren Datenbus mit R Leitungen jeweils mit R anderen Leitungen eines Datenbuses mit N · R Leitungen von dem Speicher verbunden sind, wobei die N integrierten Schalkreise zur Speicherung parallel mit demselben Adressbus mit M Leitungen verbunden sind.

3. Vorrichtung nach Anspruch 1,
dadurch gekennzeichnet, daß
der erste und der zweite Schaltkreis Treibereingänge haben, um ihre Ausgänge in einen vorgegebenen Zustand zu bringen.

4. Vorrichtung nach Anspruch 3,
dadurch gekennzeichnet, daß
der erste und der zweite Schaltkreis eine Pseudozufallsperiode von 2^{P} Binärzuständen hat, und daß der zweite Schaltkreis eine Periode von 2^{Q} Binärzuständen hat.

5. Vorrichtung nach Anspruch 2,
dadurch gekennzeichnet, daß
R gleich 1 ist.

6. Vorrichtung nach einem der Ansprüche 1 bis 5,
dadurch gekennzeichnet, daß
sie einen Schaltkreis zur Berechnung einer vorangehenden Zufallsadresse aufgrund der Kenntnis einer aktuellen Adresse umfaßt.

7. Vorrichtung nach Anspruch 6,
dadurch gekennzeichnet, daß
der Schaltkreis zur Berechnung einen Mikroprozessor und einen Programmspeicher umfaßt, wobei der Mikroprozessor mit diesem Programmspeicher verbunden ist, um ein Mikroprogramm auszuführen, das sich in diesem Programmspeicher befindet.

8. Vorrichtung nach einem der Ansprüche 1 bis 7,
dadurch gekennzeichnet, daß
der Schaltkreis zum Aneinanderhängen einen Multiplexer umfaßt.

9. Vorrichtung nach einem der Ansprüche 1 bis 8,
dadurch gekennzeichnet, daß
der Speicher ein dynamischer Speicher ist.

## Claims

1. Device for storage of coherent data following on from each other in memory words of a random access memory having a pseudo-random address generator for distributing the successive data to pseudo-random addresses in the memory, characterised in that it includes, in the pseudo-random address generator, a first circuit for successively delivering pseudo-random binary words of P bits representing first parts of address signals, and a second circuit for successively delivering contiguous binary words of Q bits representing second parts of address signals, a device for making the first and second circuits evolve in synchronism and a circuit for concatenating first and second address signal parts and thus creating a random address of P+Q bits, so as to distribute successive data in different geographical sectors of the memory.

2. Device according to Claim 1, characterised in that it includes, in the memory, an arrangement of N (N=4) integrated storage circuits each organized into 2^{M} (M=22) memory words whose length is R (R=1) bits, these N integrated circuits being connected, by their data bus with R conductors, respectively to R different conductors of a data bus with NxR conductors of the memory, these N integrated storage circuits being connected in parallel to one and the same address bus with M conductors.

3. Device according to Claim 1, characterised in that the first and second circuits have forcing inputs to force their outputs into a given state.

4. Device according to Claim 3, characterised in that the first and the second circuits have a pseudo-random period of 2^{P} binary states and in that the second circuit has a period of 2^{Q} binary states.

5. Device according to Claim 2, characterised in that R is equal to 1.

6. Device according to one of Claims 1 to 5, characterised in that it includes a circuit for calculation of a preceding random address on the basis of knowledge of a current addresses.

7. Device according to Claim 6, characterised in that the calculation circuit includes a microprocessor and a program memory, the microprocessor being connected to this program memory to run a microprogram contained in this program memory.

8. Device according to one of Claims 1 to 7, characterised in that the concatenation circuit includes a multiplexer.

9. Device according to one of Claims 1 to 8, characterised in that the memory is a dynamic memory.
